Europäisches Patentamt

European Patent Office

Office européen des brevets

(11) Veröffentlichungsnummer: **0 171 563**
B1

# (12) EUROPÄISCHE PATENTSCHRIFT

(45) Veröffentlichungstag der Patentschrift:
27.09.89

(21) Anmeldenummer: 85108081.2

(22) Anmeldetag: 01.07.85

(51) Int. Cl.⁴: **G 01 R 31/00**

(54) Schaltungsanordnung für die Belastungsprüfung von Niederspannungs-Stromquellen.

(30) Priorität: 11.07.84 DE 3425447

(43) Veröffentlichungstag der Anmeldung:
19.02.86 Patentblatt 86/8

(45) Bekanntmachung des Hinweises auf die Patenterteilung:
27.09.89 Patentblatt 89/39

(84) Benannte Vertragsstaaten:
DE FR GB

(56) Entgegenhaltungen:
DE-A- 2 704 289

(73) Patentinhaber: IBM DEUTSCHLAND GMBH,
Pascalstrasse 100, D-7000 Stuttgart 80 (DE)
Patentinhaber: International Business Machines
Corporation, Old Orchard Road, Armonk,
N.Y. 10504 (US)

(72) Erfinder: Landrock, Jürgen, Bismarckstrasse 25-1,
D-7031 Weil im Schönbuch (DE)
Erfinder: Maier, Horst, Dipl.-Ing., Schickhardstrasse 26,
D-7031 Gärtringen (DE)
Erfinder: Schmidt, Manfred, Dipl.-Phys., Dachenhäuser
Weg 37, D-7036 Schönaich (DE)
Erfinder: Perske, Manfred, Ing., Hohenstaufenstrasse 62,
D-7032 Sindelfingen (DE)
Erfinder: Tandjung, Halim, Dipl.-Ing., Nürtinger
Strasse 75, D-7030 Böblingen (DE)

(74) Vertreter: Mönig, Anton, Dipl.-Ing., IBM Deutschland
GmbH Schönaicher Strasse 220, D-7030 Böblingen (DE)

## Beschreibung

Die Erfindung betrifft eine Schaltungsanordnung für die statische und dynamische Belastungsprüfung von vorzugsweise Niederspannungs-Stromquellen.

Derartige Stromquellen dienen insbesondere als Netzgeräte der Strom- und Spannungsversorgung von integrierten Halbleiterschaltungen. Selbstverständlich kommt es dabei nicht auf die Art der anzuschliessenden Geräte an, sondern nur auf die Prüfung der Belastbarkeit der Stromquellen mit Spannungen von 0,1 Volt an bei Stromstärken bis zu 400 A und bei Leistungen von weit mehr als 600 Watt. Dabei soll die Belastbarkeit nicht nur mit Gleichstrom, sondern auch mit Wechselspannungen beliebiger Wellenformen bis zu Sprungfunktion prüfbar sein. Nur so lässt sich eine zuverlässige Aussage über die Belastbarkeit der Stromquellen gewinnen, die nachher im Dauerbetrieb den Verbraucher mit höchster Zuverlässigkeit mit Spannungen und Strömen versorgen müssen. Insbesondere sollte die Grenz-Betriebsfrequenz bis zu 600 KHz betragen.

Es gibt bereits eine Reihe solcher Prüfgeräte im Handel, die jedoch jeweils nur Teile der zu stellenden Forderungen zu erfüllen vermögen. Als besonders wichtige Forderung ist aber anzusehen, dass sich das neue Gerät zum Anschluss an eine Datenverarbeitungsanlage über eine IEEE-Schnittstelle für eine programmierte vollautomatische Prüfung von Netzgeräten eignen muss.

Es ist dabei bereits bekannt, Feldeffekttransistoren als steuerbare Lastwiderstände einzusetzen, mit deren Hilfe eine gewisse Konstanz der Belastung eingehalten werden kann.

Die der Erfindung zugrundeliegende Aufgabe lässt sich kurz zusammengefasst so definieren: nämlich ein Gerät zu schaffen, das diese Forderungen in jeder Hinsicht zu erfüllen vermag.

Dies wird erfindungsgemäss dadurch erreicht, dass zwischen dem Prüfsignalgenerator und einem am Ausgang des dynamischen Lastwiderstandes angeschlossenen Abfühlwiderstand ein Steuer- und Regelverstärker mit Vergleichsstufe zum Vergleich der Wellenform des Eingangssignals mit der Wellenform des über dem Abfühlwiderstand abgegriffenen Ausgangssignals des dynamischen Lastwiderstandes vorgesehen ist, über den eine Nachregelung der an die Gateelektrode des dynamischen Lastwiderstandes angelegten Steuerspannung so lange und so oft erfolgt, bis beide Signale die identisch gleiche Wellenform aufweisen.

Weitere Ausgestaltungen der Erfindung sind den weiteren Ansprüchen zu entnehmen.

Die Erfindung wird nun anhand eines bereits gebauten und voll arbeitsfähigen Ausführungsbeispieles in Verbindung mit den beigefügten Zeichnungen näher erläutert.

In den Zeichnungen zeigt:

Fig. 1 Prinzipschaltbild der Erfindung und
Fig. 2 ein Strom-Zeitdiagramm bei Sprungfunktionsbetrieb.

Für die Prüfung von Niederspannungs-Stromquellen, insbesondere von Transistor-Netzgeräten verwendet man statische Lastwiderstände, um vorgegebene minimale und maximale Ströme zu ziehen. Ein veränderbarer dynamischer Lastwiderstand wird zur Messung des dynamischen Widerstandes und der Regelung des Netzgerätes eingesetzt. Dabei werden beide Belastungen gleichzeitig für eine Nachbildung der tatsächlichen im Betrieb auftretenden Bedingungen eingesetzt.

Bei sehr niedrigen Niederspannungen von weniger als 0,5 bis 1,0 Volt bei hohen Stromstärken sind automatische, die Wirklichkeit nachbildende Belastungsprüfungen bisher nicht möglich gewesen.

Eine grundlegende Überlegung, die zu der erfindungsgemässen Lösung führte, war folgende:

Als steuerbare Lastwiderstände arbeitende Feldeffekttransistoren haben einen in einem gewissen linearen Bereich veränderbaren Widerstand. Will man extrem kleine Widerstände für extrem niedrige Spannungsabfälle, aber für gleichzeitig sehr hohe Ströme verwirklichen, dann bietet es sich an, eine grössere Anzahl solcher FET's parallel zu schalten. Dabei ist aber zu berücksichtigen, dass die Steilheit und die Länge des geraden Tals der Widerstandskennlinie der einzelnen Transistoren keinesfalls identisch ist. Dies schränkt aber die Regelmöglichkeit bei zunehmender Anzahl parallel geschalteter Transistoren immer stärker ein. Ferner muss man berücksichtigen, dass man an sich die dynamische Belastungsprüfung mit genau bestimmten Wellenformen durchführen muss, um zu vergleichbaren, aussagekräftigen Ergebnissen zu kommen. Jede Transistorparallelschaltung wird also zwangsläufig das am Eingang den Gateelektroden zugeführte definierte Eingangssignal undefiniert verzerren. Dies ist untragbar.

Daher der Lösungsgedanke:

Man entnimmt dem Ausgang der Transistorgruppe das verzerrte Ausgangssignal und führt dieses einem Steuer- und Regelverstärker mit Vergleicher zu. Dann wird das dem Eingang des Lastwiderstandes zugeleitete Signal so lange und so vorverzerrt, bis am Ausgang des Lastwiderstandes und damit am Eingang des zu prüfenden Netzgerätes ein Signal mit der gleichen Wellenform wie das zugeführte Signal liegt.

Die Prinzipschaltung soll nun im einzelnen beschrieben werden, wobei dann noch näher auf die Regelung des statischen Teils eingegangen wird.

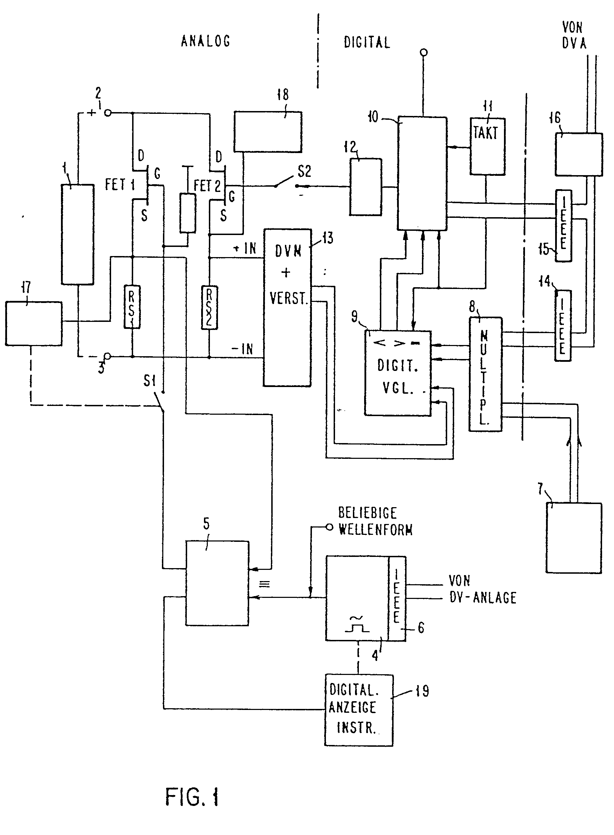

In Fig. 1 ist links oben schematisch ein Prüfling 1 angedeutet, der an den Klemmen 2, 3 angeschlossen wird. Zu diesen Ausgangsklemmen sind zwei als steuer- und regelbare Lastwiderstände arbeitende Feldeffekttransistoren FET 1 und FET 2, jeweils in Reihe mit einem Abfühlwiderstand RS 1 bzw. RS 2 parallel geschaltet, wobei die Abfühlwiderstände auch als Bezugs- und Referenzwiderstände dienen. Im vorliegenden Fall besteht jeder Lastwiderstand aus einer Anzahl parallel geschalteter Feldeffekttransistoren. Dadurch kann der Gesamtwiderstand der Lastwiderstände sehr klein gemacht werden. Dies ist bei der Prüfung mit sehr kleinen Spannungen in der Grössenordnung von ca. 0,5 bis 1,0 Volt wichtig.

Beide Transistoren werden mit Analogsignalen betrieben. Der Lastwiderstand FET 1 dient dabei der dynamischen Prüfung mit Wechselspannungen beliebiger aber reproduzierbarer Kurvenform, während der Lastwiderstand FET 2 der statischen Belastungsprüfung mit einem beliebig vorwählbaren Strom dient.

Die Regelung für die dynamische Ansteuerung erfolgt dynamisch und analog, die Regelung der statischen Ansteuerung digital.

Dies soll anhand des Schaltbildes erläutert werden.

Ein Sinus/Rechteckgenerator 4 ist an einem Eingang einer Vergleichsstufe eines Steuer- und Regelverstärkers 5 angeschlossen. Ein weiterer Eingang ist für ein Eingangssignal beliebiger Wellenform vorgesehen. Der Ausgang des Steuer- und Regelverstärkers 5 ist mit der Gateelektrode des FET 1 verbunden. An der Sourceelektrode tritt über dem Abfühlwiderstand RS 1 ein normalerweise verzerrtes Ausgangssignal auf, das aber eigentlich die identisch gleiche Wellenform aufweisen sollte wie das Eingangssignal. Um das zu erreichen, wird dieses verzerrte Ausgangssignal der Vergleichsstufe zugeführt und mit dem Eingangssignal verglichen. Damit wird im Steuer- und Regelverstärker 5 das den FET 1 steuernde Signal so lange verändert, bis das Eingangssignal und das Ausgangssignal eine identische Wellenform aufweisen. Dies hat zunächst den Vorteil, dass die Prüfung zuverlässig mit einer genau bekannten Wellenform erfolgt. Weiterhin hat dies den Vorteil, dass bei Erwärmung der Transistoren und dadurch sich ergebenden Veränderungen oder Verzerrungen diese sofort kompensiert werden können. Ein ganz gewichtiger Vorteil besteht aber darin, dass keine besonders ausgesuchten Feldeffekttransistoren mit möglichst identischem Kennlinienverlauf verwendet werden müssen. Es können beliebige Feldeffekttransistoren der gleichen Type ab Lager verwendet werden. An dem Sinus/Rechteckgenerator 4 kann ausserdem noch eine IEEE-Schnittstelle 6 für eine Ansteuerung durch eine Datenverarbeitungsanlage vorgesehen sein.

Für die statische Strom-Belastungsprüfung ist ein digitaler Stromauswahlschalter 7 vorgesehen, in dem die gewünschte Prüfstromstärke von etwa 1 mA bis z.B. 120 A eingegeben werden kann. Dieses Signal gelangt über eine Vielfachleitung mit z.B. 20 Leitungen an einen Multiplex-Schalter 8 und von dort an eine digitale Vergleichsschaltung 9.

Ausserdem ist ein digitaler Aufwärts/Abwärtszähler 10 mit Register vorgesehen, der gemeinsam mit der Vergleichsschaltung von einem Taktgenerator 11 gesteuert wird.

Beim Einschalten wird der Zähler 10 automatisch auf Null zurückgestellt. Das Zählersignal liegt von Anfang an an einem Digital/Analogwandler 12, der ausgangsseitig mit der Gateelektrode des Lastwiderstandes FET 2 verbunden ist. Der durch den FET 2 eingeprägte Strom liefert über dem Abfühlwiderstand RS 2 eine Spannung, die in einem Analog/Digitalwandler mit Verstärker 13 digitalisiert ist, in einem Digital-Voltmeter angezeigt und der digitalen Vergleichsschaltung 9 zugeführt wird. Da dieses Signal zunächst mit Sicherheit kleiner ist als das Eingangssignal, wird der Zähler 10 veranlasst, so lange aufwärts zu zählen, bis beide digitalen Werte gleich sind. Wenn sich jetzt im Betrieb am FET 2 etwas ändert, d.h. der Strom grösser oder kleiner wird, kann das sofort festgestellt und unverzüglich korrigiert werden. In dieser Position können vor allem Sprungfunktionen, Einschalt- und Ausschaltstromstösse simuliert werden. Der Zähler 10 und die digitale Vergleichsschaltung 9 können ausserdem über je eine IEEE-Schnittstellenschaltung 14 bzw. 15 über einen OPTO-Koppler 16 durch eine DV-Anlage gesteuert werden. Auch hier gilt das gleiche. Es sind keine besonders ausgesuchten Feldeffekttransistoren erforderlich, man kann sie unmittelbar vom Lager nehmen.

Als Schutz gegen Überstrom, zu hohe Leistung, als Überlastschutz sind zwei Notschalter 17, 18 vorgesehen, die jeweils zwischen Sourceelektrode der FET 1 bzw. FET 2 und Abfühlwiderstand RS 1 bzw. RS 2 angeschlossen sind und bei Überstrom bzw. Überlast den Schalter S 1 bzw. S 2 betätigen und damit die Ansteuerung der Feldeffekttransistoren unterbrechen.

Ausserdem ist an der Vergleichsstufe des Steuer- und Regelverstärkers noch ein digitales Anzeigeinstrument 19 angeschlossen.

In einer tatsächlich aufgebauten Schaltung gemäss der Erfindung betrug die kleinste Spannung, mit der noch geprüft werden konnte, 0,1 Volt bei bis zu 10 Ampere Stromstärke bzw. 1,2 Volt bei 120 Ampere. Diese Leistung lässt sich bei verbesserter Kühlung und Einsatz weiterer Leitungs-FET's noch beträchtlich steigern. Dies trifft auch für die zunächst höchste Leistung von 600 W zu.

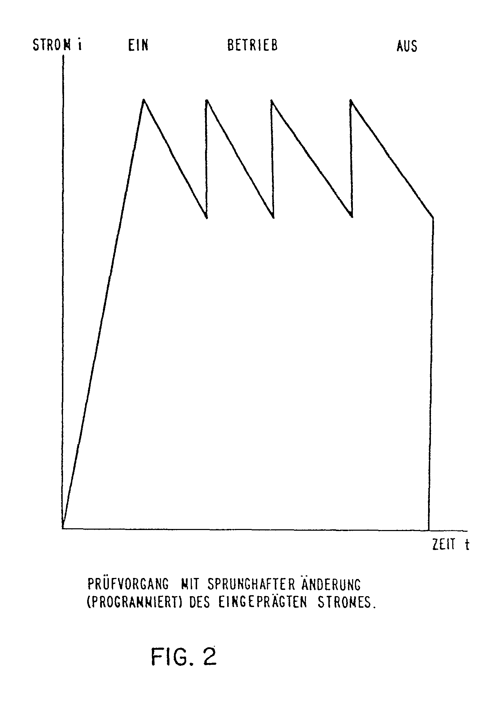

Der Betrieb war mit jeder beliebigen Wellenform möglich. Die höchste Betriebsfrequenz betrug 600 KHz. Als besonders wichtig erschien, dass die Prüfung mit statischen Sprungfunktionen durchgeführt werden konnte. Dies zeigt das Diagramm in Fig. 2.

Dies hat z.B. besondere Bedeutung für die Prüfung von Netzgeräten von Schnelldruckern, da damit beliebige Ströme der Druckhammermagnete simuliert werden können.

Insgesamt hat die erfindungsgemässe Schaltung folgende Eigenschaften:

1. Hohe Strombelastbarkeit bei sehr kleinen Spannungen;
2. Simulation eines Kurzschlusses auf der Sekundärseite;
3. Simulation von Einschalt-Ausschalt-Stromstössen;

4. Volle Flexibilität bezüglich der Wellenform des Prüfsignals für die dynamische Belastungsprüfung;

5. Hohe Grenzfrequenz;

6. Volle Temperaturkompensation durch ständige Nachregelung;

7. Niedrige Kosten;

8. Beträchtliche Verringerung der Prüfzeit und

9. Möglichkeit für vollautomatischen, durch DV-Anlage gesteuerten Betrieb.

Es ist also einleuchtend, dass die gesteckten Ziele voll erreicht werden konnten.

**Patentansprüche**

1. Schaltungsanordnung für die statische und dynamische Belastungsprüfung von vorzugsweise Niederspannungs-Stromquellen unter Verwendung von gesteuerten Feldeffekttransistoren als statische bzw. dynamische Lastwiderstände sowie mit einem Prüfsignalgenerator (4) für die Erzeugung von Prüfsignalen unterschiedlicher Wellenform mit vorgegebener Amplitude und mit einem digitalen Eingangswahlschalter (7) für die Auswahl der dem Prüfling einzuprägenden Eingangsstromstärke, dadurch gekennzeichnet, dass zwischen dem Prüfsignalgenerator (4) und einem am Ausgang des dynamischen Lastwiderstandes (FET 1) angeschlossenen Abfühlwiderstand (RS 1) ein Steuer- und Regelverstärker (5) mit Vergleichsstufe zum Vergleich der Wellenform des Eingangssignals mit der Wellenform des über dem Abfühlwiderstand (RS 1) abgegriffenen Ausgangssignals des dynamischen Lastwiderstandes (FET 1) vorgesehen ist, über den eine Nachregelung der an die Gateelektrode des dynamischen Lastwiderstandes angelegten Steuerspannung so lange und so oft erfolgt, bis beide Signale die identisch gleiche Wellenform aufweisen.

2. Schaltungsanordnung nach Anspruch 1, dadurch gekennzeichnet, dass für die statische Belastungsprüfung ein zweiter Lastwiderstand (FET 2) vorgesehen ist, der eingangsseitig an seiner Gateelektrode mit einem im digitalen Stromauswahlschalter (7) einstellbaren eingeprägten Strom ansteuerbar ist.

3. Schaltungsanordnung nach Anspruch 2, dadurch gekennzeichnet, dass das die Eingangssignal-Stromstärke bestimmende Signal über eine digitale Vergleichsschaltung (9) und einen digitalen Aufwärts-Abwärtszähler (10) mit Speicher und einem Digital-Analogwandler (12) der Gateelektrode des statischen Lastwiderstandes (FET 2) zuleitbar ist, und dass das an einem mit diesem Lastwiderstand (FET 2) in Reihe geschalteten Abfühlwiderstand (RS 2) abgegriffene Ausgangssignal über einen Analog-Digitalwandler (13) der digitalen Vergleichsschaltung zuführbar ist, die ausserdem an dem Aufwärts-Abwärtszähler (10) angeschlossen ist, so dass beim Einschalten und im Betrieb die eingegebene Signalstromstärke ständig auf ihren Sollwert einregelbar ist.

4. Schaltungsanordnung nach den Ansprüchen 1 bis 3, dadurch gekennzeichnet, dass ein Taktgenerator (11) für die Taktsteuerung des Aufwärts-Abwärtszählers (10) und der Vergleichsschaltung (9) vorgesehen ist.

5. Schaltungsanordnung nach den Ansprüchen 1 bis 4, dadurch gekennzeichnet, dass für die Lastwiderstände (FET 1, FET 2) jeweils eine Anzahl Feldeffekttransistoren parallel geschaltet ist, wodurch sich der jeweils steuerbare Lastwiderstand beliebig klein machen lässt.

6. Schaltungsanordnung nach Anspruch 1 bis 5, dadurch gekennzeichnet, dass in der Ansteuerleitung jedes Lastwiderstandes (FET 1, FET 2) jeweils ein Schalter (S 1, S 2) angeordnet ist, der jeweils durch einen am entsprechenden Ausgang der die Lastwiderstände bildenden Feldeffekttransistoren angeschlossenen Überlast- Überstrom-Notschalter (17, 18) zur Unterbrechung der Steuerleitung schaltbar ist.

7. Schaltungsanordnung nach Anspruch 3, dadurch gekennzeichnet, dass der Analog-Digitalwandler (13) mit einem Digital-Spannungsmesser und einem Verstärker kombiniert ist, der eingangsseitig über dem Abfühlwiderstand (RS 2) im Ausgang des statischen Lastwiderstandes (FET 2) angeschlossen und ausgangsseitig mit der Vergleichsschaltung (9) verbunden ist, und dass der Zähler (10) über drei Ausgänge (grösser, kleiner, gleich) mit der Vergleichsschaltung verbunden und durch diese steuerbar ist.

8. Schaltungsanordnung nach Anspruch 1 bis 7, dadurch gekennzeichnet, dass die gesamte Schaltung aus einem digital arbeitenden Eingangsteil mit dynamischer digitaler Regelung des einzuprägenden digitalen Stroms und aus einem analog arbeitenden Teil besteht, der die beiden Lastwiderstände und die dynamisch arbeitende Regelschaltung für die wellenformgetreue Ansteuerung des zu prüfenden Gerätes enthält.

9. Schaltungsanordnung nach Anspruch 8, dadurch gekennzeichnet, dass am Eingang der Vergleichsschaltung (9) ein Multiplex-Schalter (8) angeschlossen ist, und dass an dessen Eingängen der digitale Stromauswahlschalter (7) und eine digitale IEEE-Schnittstellenschaltung (14) angeschlossen sind, und dass ferner an einem weiteren Eingang des Aufwärts-Abwärtszählers (10) ebenfalls eine digitale IEEE-Schnittstellenschaltung (15) angeschlossen ist.

**Claims**

1. Circuit arrangement for statically and dynamically load testing preferably low-voltage current sources, utilizing controlled field-effect transistors as static and dynamic load resistors, respectively, comprising a test signal generator (4) for generating test signals of different waveform and predetermined amplitude, and a digital input selection switch (7) for selecting the input current strength to be impressed on the sample, characterized in that between the test signal generator (4) and a sense resistor (RS 1), connected to the output of the dynamic load resistor (FET 1), a control and variable-gain amplifier (5) is provided having a compare stage for comparing the waveform of the input signal with the waveform of the output signal of the dynamic load resistor (FET 1) picked up from the sense resistor (RS 1), and being used to adjust the control voltage applied to the gate electrode of the dynamic load resistor for as long and as often as it takes both signals to reach exactly the same waveform.

2. Circuit arrangement according to claim 1, characterized in that for static load testing, a second load resistor (FET 2) is provided which is controlled on its gate electrode by an impressed current adjustable by the digital current selection switch (7).

3. Circuit arrangement according to claim 2, characterized in that the signal determining the current strength of the input signal is applied through a digital compare circuit (9) and a digital upward/downward counter (10) with a memory and a digital-to-analog converter (12) to the gate electrode of the static load resistor (FET 2), and that the output signal picked up from a sense resistor (RS 2), series-connected to the load resistor (FET 2), is applied through an analog-to-digital converter (13) to the digital compare circuit which is also connected to the upward/downward counter (10) so that when the circuit is activated and during operation the input signal current strength is continuously adjusted to its desired value.

4. Circuit arrangement according to claims 1 to 3, characterized in that a clock generator (11) is provided for the control of the upward/downward counter (10) and the compare circuit (9).

5. Circuit arrangement according to claims 1 to 4, characterized in that for the load resistors (FET 1, FET 2), a number of field-effect transistors are connected in parallel, so that the respective controllable load resistance can be made arbitrarily small.

6. Circuit arrangement according to claims 1 to 5, characterized in that the control line of each load resistor (FET 1, FET 2) comprises in each case one switch (S1, S2) switched by an overload/overcurrent emergency switch (17, 18) which is connected to the respective output of the field-effect transistors forming the load resistors and which serves to interrupt the control line.

7. Circuit arrangement according to claim 3, characterized in that the analog-to-digital converter (13) is combined with a digital voltmeter and an amplifier having its input side connected to the output of the static load resistor (FET 2) through the sense resistor (RS 2) and having its output side connected to the compare circuit (9), and that the counter (10) with three outputs (greater, smaller, equal) is connected to the compare circuit and controlled thereby.

8. Circuit arrangement according to claims 1 to 7, characterized in that the entire circuit consists of a digitally operating input portion with dynamic digital control of the digital current to be impressed and of an analogously operating portion comprising the two load resistors and the dynamically operating control circuit for controlling the device to be tested according to the respective waveform.

9. Circuit arrangement according to claim 8, characterized in that a multiplex switch (8) is connected to the input of the compare circuit (9), and that the digital current selection switch (7) and a digital IEEE interface circuit (14) are connected to the inputs of said multiplex switch, and that in addition a digital IEEE interface circuit (15) is connected to a further input of the upward/downward counter (10).

**Revendications**

1. Montage pour réaliser l'essai en charge, statique et dynamique, de préférence de sources de courant à basse tension, moyennant l'utilisation de transistors à effet de champ commandés en tant que résistances de charge statiques ou dynamiques, ainsi qu'un générateur (4) de signaux de contrôle servant à produire des signaux de contrôle possédant des formes d'ondes différentes et une amplitude prédéterminée, et un commutateur numérique de sélection d'entrée (7) servant à sélectionner l'intensité du courant d'entrée, devant être injectée dans l'unité à tester, caractérisé en ce qu'entre le générateur (4) de signaux de contrôle et une résistance de détection (RS 1) raccordée à la sortie de la résistance de charge dynamique (FET 1), il est prévu un amplificateur de commande et de régulation (5), qui comporte un étage comparateur servant à comparer la forme d'onde du signal d'entrée à la forme d'onde du signal de sortie, de la résistance de charge dynamique (FET 1), prélevé par l'intermédiaire de la résistance de détection (RS 1), et au moyen duquel un réglage d'asservissement de la tension de commande appliquée à l'électrode de grille de la résistance de charge dynamique est réalisé jusqu'à ce que et aussi souvent que les deux signaux possèdent la même forme d'onde.

2. Montage selon la revendication 1, caractérisé en ce que pour le contrôle statique de la charge il est prévu une seconde résistance de charge (FET 2), qui peut être commandée, sur son côté entrée, au niveau de son électrode de grille, par un courant réglable injecté dans l'interrupteur numérique (7) de sélection du courant.

3. Montage selon la revendication 2, caractérisé en ce que le signal déterminant l'intensité du courant du signal d'entrée peut être envoyé par l'intermédiaire d'un circuit comparateur numérique (9) et d'un compteur progressif/régressif numérique (10) comportant une mémoire, et d'un convertisseur numérique/analogique (12), à l'électrode de grille de la résistance de charge statique (FET 2), et que le signal de sortie prélevé sur une résistance de détection (RS 2) branchée en série avec cette résistance de charge (FET 2), peut être envoyé par l'intermédiaire d'un convertisseur analogique/numérique (13) au circuit comparateur numérique, qui est en outre raccordé au compteur progressif/régressif (10), de sorte que lors du branchement et pendant le fonctionnement, l'intensité du courant de signal introduit est réglable en permanence sur sa valeur de consigne.

4. Montage selon les revendications 1 à 3, caractérisé en ce qu'il est prévu un générateur de cadence (11) servant à commander la cadence du compteur progressif/régressif (10) et du circuit comparateur (9).

5. Montage suivant l'une des revendications 1 à 4, caractérisé par le fait qu'il est prévu, pour les résistances de charge (FET 1, FET 2), respectivement un certain nombre de transistors à effet de champ branchés en parallèle, ce qui permet de choisir la résistance de charge respectivement commandable, aussi petite qu'on le désire.

6. Montage selon les revendications 1 à 5, caractérisé en ce que dans la ligne de commande de chaque résistance de charge (FET 1, FET 2) se trouve disposé respectivement un interrupteur (S1, S2), qui peut être commuté respectivement par un disjoncteur d'arrêt d'urgence à surintensité (17, 18) raccordé à la sortie correspondante des transistors à effet de champ formant les résistances de charge, en vue d'interrompre la ligne de commande.

7. Montage selon la revendication 3, caractérisé en ce que le convertisseur analogique/numérique (13) est combiné à un voltmètre numérique et à un amplificateur, qui est raccordé, côté entrée, par l'intermédiaire d'une résistance de détection (RS 2) à la sortie de la résistance de charge statique (FET 2) et relié, côté sortie, au circuit comparateur (9), et que le compteur (10) est relié par l'intermédiaire de trois sorties (supérieure, inférieure, égale) au circuit comparateur et peut être commandé par ce dernier.

8. Montage selon les revendications 1 à 7, caractérisé en ce que l'ensemble du circuit est formé par une partie d'entrée fonctionnant numériquement, avec une régulation numérique dynamique du courant numérique devant être injecté, et par une partie fonctionnant de façon analogique, qui contient les deux résistances de charge et le circuit de régulation travaillant de façon dynamique pour réaliser la commande, fidèle du point de vue de la forme d'onde, de l'appareil à contrôler.

9. Montage selon la revendication 8, caractérisé en ce qu'à l'entrée du circuit comparateur (9) est raccordé un commutateur de multiplexage (8), aux entrées duquel sont raccordés le commutateur numérique de sélection de courant (7) et un circuit d'interface IEEE numérique (14), et qu'en outre un circuit d'interface IEEE numérique (15) est également raccordé à une autre entrée du compteur progressif/régressif (10).

FIG. 1

PRÜFVORGANG MIT SPRUNGHAFTER ÄNDERUNG
(PROGRAMMIERT) DES EINGEPRÄGTEN STROMES.

FIG. 2